# EUROPÄISCHE PATENTSCHRIFT

(11) **EP 1 130 136 B1**
(45) Veröffentlichungstag und Bekanntmachung des Hinweises auf die Patenterteilung: **23.10.2002**
(21) Anmeldenummer: 01105178.6
(22) Anmeldetag: 02.03.2001
(51) Int. Cl.: C30B 29/12, G02B 1/02, C30B 33/02

(54) **Verfahren zur Herstellung grossformiger Einkristalle aus Calciumfluorid sowie deren Verwendung in der Fotolitographie**
Process for manufacturing large single crystals of calcium fluoride and the use of the crystals in Photolithography
Procédéde fabrication de grandes monocristaux de fluorure de calcium et l'utilisation de ces cristaux pour la photolithographie

(30) Priorität: 03.03.2000 DE 10010485
(43) Veröffentlichungstag der Anmeldung: 05.09.2001
(73) Patentinhaber: Schott Glas, 55122 Mainz (DE)
(72) Erfinder: Stäblein, Jörg, 07743 Jena (DE); Weisleder, Andreas, 07639 Tautenhain (DE); Wehrhan, Gunther, Dr., 07749 Jena (DE); Speit, Burkhard, Dr., 07745 Jena (DE); Parthier, Lutz, Dr., 10051 Berlin (DE)
(74) Vertreter: Fuchs Mehler Weiss & Fritzsche, Patentanwälte

(56) Entgegenhaltungen:
- EP-A- 0 939 147
- EP-A- 0 972 863
- DATABASE WPI Section Ch, Week 198503 Derwent Publications Ltd., London, GB; Class E33, AN 1985-012921 XP002169271 & DD 213 514 A (VEB CARL ZEISS JENA), 12. September 1984 (1984-09-12)

## Beschreibung

Die Erfindung betrifft ein Verfahren zur Herstellung von hochhomogenen, großformatigen Einkristallen aus Calciumfluorid durch Tempern bei erhöhter Temperatur insbesondere in einem Ofen sowie deren Verwendung.

Einkristalle, insbesondere Calciumfluorid-Einkristalle werden als Ausgangsmaterial für optische Komponenten in der DUV-Fotolithographie wie Stepper oder Excimerlaser benötigt. Sie werden üblicherweise als Linsen oder Prismen verwendet und dienen insbesondere dazu, bei der Herstellung von elektronischen Geräten feine Strukturen auf integrierten Schaltungen, sowie auf Computerchips und/oder auf Fotolack-beschichteten Wafern optisch abzubilden. Hierzu ist es notwendig, dass diese optischen Bauteile eine hohe Homogenität aufweisen, d.h. dass ihre Brechzahl n im gesamten Kristall äußerst konstant sein muss. Dies bedeutet, dass sich die Brechzahl über das gesamte Kristallvolumen hinweg um eine Differenz Δn von höchstens 5 x 10⁻⁶, zweckmäßigerweise um höchstens 2 x 10⁻⁶ unterscheiden soll. Da andererseits der Bedarf an derartigen Schaltungen und Computerchips laufend steigt, muss deren Produktion ebenfalls laufend gesteigert werden. Dazu werden immer größere Wafer benötigt. So werden beispielsweise inzwischen häufiger Waferdurchmesser von 200 mm und darüber hinaus benötigt. Dies setzt jedoch auch voraus, dass die Durchmesser der zur Belichtung der Wafer notwendigen optischen Bauteile ebenfalls entsprechend größer sind. Um winzige Schaltungen bzw. Computerchips mit hohem Durchsatz herstellen zu können, sollten daher die Differenzen in den an unterschiedlichen Stellen des Kristallvolumens bestimmten Brechzahlen nicht größer als 1 x 10⁻⁶ sein.

Die Herstellung von Einkristallen sowie entsprechend großen optischen Elementen ist an sich bekannt. Sie können im Prinzip aus der Gasphase, der Schmelze, aus Lösungen oder sogar aus einer festen Phase durch Rekristallisation oder Festkörperdiffusion gezüchtet werden. Unterschiedliche Verfahren zum Züchten von Kristallen sind dem Fachmann bekannt und werden z.B. in Lehrbüchern wie dem 1088 Seiten umfassenden Werk von K.-Th.-Wilke und J. Bohm "Kristallzüchtung", Verlag Harri Deutsch, Thun, Frankfurt/Main 1988 (ISBN 3-87144-971-7) beschrieben.

Zur technischen Herstellung werden jedoch Einkristalle üblicherweise durch Erstarren einer Schmelze gezüchtet. Für die industrielle Fertigung von Einkristallen hat sich beispielsweise das sogenannte Stockbarger-Bridgman und das Vertical Gradient Freeze-Verfahren durchgesetzt, wo in einem Ziehofen und bei einem Vakuum von 10⁻⁴ - 10⁻⁵ mbar der Kristall gezüchtet wird. Dabei wird eine Kristallrohmasse aufgeschmolzen, wobei unter genauester Steuerung der Temperatur ein homogener Einkristall erhalten wird.

Zur Herstellung der Einkristalle wurde bislang derart vorgegangen, dass die Kristallrohmasse in einem Tiegel langsam auf die Verdampfungstemperatur des Wassers von etwa 400°C aufgeheizt wurde und unter Entwässerung des Rohstoffes einige Zeit bei dieser Temperatur gehalten wurde. Danach wurde die Temperatur in einem Zeitraum von etwa 20 Stunden auf 1450°C erhöht, wobei mittels in den Rohstoff beigemischten Scavenger wie PbF₂, SnF₂, oder ZnF₂, der Sauerstoff entfernt wurde. Dabei reagierten die zugesetzten Scavenger mit dem zum Teil durch Oxidation und/oder Hydrolyse entstandenen und in der Rohmasse vorliegenden Sauerstoff zu leicht flüchtigen Oxiden, welche bei dieser Temperatur verdampften. Danach erfolgte eine üblicherweise einwöchige sogenannte Aufreinigung bei 1450°C mit anschließender langsamer mehrwöchiger Abkühlung auf etwa 1200°C, wobei sich der gewünschte Kristall aus der Schmelze abschied. Der so erhaltene Einkristall wurde dann in einer ersten langsamen Abkühlphase und dann in einer danach geschalteten zweiten beschleunigten Abkühlphase auf Raumtemperatur abgekühlt.

Da der Wärmefluss in einer derartigen Kristallzuchtanlage nicht vollständig zu beherrschen ist, entstehen bei der Kristallisation regelmäßig sogenannte Spannungsdoppelbrechungen. Darüber hinaus bilden sich auch verschiedene Kristallorientierungen aus, sog. Blockbildung. Obwohl die CaF₂-Einkristalle während ihrer Herstellung auch noch nach der Kristallisation lange auf einer hohen Temperatur gehalten werden, beträgt nach ihrer Zucht die Spannungsdoppelbrechung üblicherweise noch 5 - 20 nm/cm, was für die spätere Verwendung zu groß ist. Durch Zersägen des Einkristalles und durch das mechanische Bearbeiten der optischen Elemente wie Fräsen und Polieren, wird die ohnehin hohe Spannungsdoppelbrechung noch weiter erhöht.

Aus diesem Grund sind bereits Versuche unternommen worden, die Homogenität derart hergestellter Einkristalle dadurch zu verbessern, dass man diese über einen längeren Zeitraum auf eine Temperatur unterhalb des Schmelzpunktes erwärmt. Es ist daher bekannt, zur Erreichung der gewünschten hohen Homogenität, den Kristall nach seiner Fertigstellung über eine längere Zeit einer erhöhten Temperatur auszusetzen, bei der durch Umordnung der Atome im Kristallgitter sich sowohl mechanische Spannungen als auch optische Fehler auflösen oder zumindest verringern. Dieser Vorgang wird üblicherweise als Tempern bezeichnet.

So wird zum Beispiel in der DD-PS-213514 ein Temperverfahren beschrieben, bei dem in einer PbF₂-haltigen Atmosphäre bei einem PbF₂-Partialdruck von 0,01 - 1 Torr (1,33 Pa-133,3 Pa) bei einer Temperatur von 1200°C ein Calciumfluorid-Kristall erhitzt wird. Dabei ist es die Aufgabe des PbF₂ noch vorhandenen Restsauerstoff im Calciumfluorid-Kristall zu gettern. Bei diesem Verfahren werden bei einem Kristall mit einem Durchmesser von 20 mm und einer Dicke von 10 mm eine vorhandene Spannungsdoppelbrechung von 10 bis 25 nm/cm durch eine zwei- bis dreistündige Erwärmung auf 1200°C auf nur 1 nm/cm verringert. Mit diesem Verfahren war es jedoch nicht möglich, eine Spannungsdoppelbrechung bei wesentlich größeren Calciumfluorid-Einkristallen, d.h. bei Einkristallen mit einem Durchmesser von größer als 200 mm insbesondere solchen größer als 300 mm und Dicken von 50 - 400 mm oder auch von entsprechend großformatigen bereits bearbeiteten und fertig polierten optischen Elementen in wirtschaftlichen Verfahrenszeiten zu verbessern. Beim Versuch, die Temperzeit dadurch zu verkürzen und/oder eine bessere Temperung dadurch zu erreichen, dass man die Tempertemperatur noch weiter erhöht, hat es sich nämlich gezeigt, dass dabei die Einkristalle sehr stark an Volumen verlieren. Auch fertige Optiken verlieren die bearbeitete Form rasch.

In der EP-A-939 147 ist ein Verfahren zur Herstellung von Calciumfluorid, insbesonders für die Fotolithographie beschrieben. Dabei werden große Einkristalle in einem verschließbaren Behälter eingebracht und unter Vakuum auf eine erste Temperatur erhitzt, welche in einem Bereich von 1020°C und 1150°C liegt und danach mit einer Abkühlgeschwindigkeit von höchstens 1,2°C-2°C/h auf eine Temperatur von 600 - 900°C in einer ersten Phase abgekühlt, wonach sich eine Abkühlung auf Raumtemperatur mit einer Abkühlgeschwindigkeit von höchstens 5°C/h anschließt. In bevorzugten Ausführungsformen wird das Tempern in einer Fluorgasenthaltenden Atmosphäre sowie unter Schutzgas durchgeführt.

Es hat sich jedoch gezeigt, dass mit den bekannten Verfahren keine befriedigende Homogenität in ausreichender Ausbeute erreicht wird.

Die Erfindung hat daher zum Ziel, die zuvor genannten Probleme zu überwinden und hochhomogene Einkristalle sowie daraus hergestellte optische Elemente mit befriedigender Ausbeute bereitzustellen, die eine hohe Homogenität mit einer geringen Spannungsdoppelbrechung und konstanter Brechzahl aufweisen, d.h. dass an verschiedenen Stellen bestimmte Brechzahlen nicht mehr als Δn = 5 x 10⁻⁶ voneinander abweichen.

Die Erfindung hat auch zum Ziel, die Ausbildung verschiedener Kleinwinkelkorngrenzen oder anderer niederdimensionaler Kristalldefekte zu vermindern und/oder zu beseitigen.

Schließlich hat die Erfindung noch zum Ziel, beim Tempern eine Schleierbildung im Kristall zu vermeiden oder zu verringern.

Diese Ziele werden durch das in den Ansprüchen definierte Verfahren erreicht.

Es hat sich nämlich überraschenderweise gezeigt, dass sich mechanische Spannung, Kleinwinkelkorngrenzen sowie Spannungsdoppelbrechungen beseitigen bzw. verringern lassen, wenn man den fertigen Einkristall auf eine Temperatur von über 1150°C in Gegenwart von fein verteiltem Caiciumfluoridpulver erwärmt.

Es hat sich gezeigt, dass sich unter den erfindungsgemäßen Bedingungen überraschenderweise auch Kleinwinkelkorngrenzen, zellulare Strukturen und sogenannte Zwillinge, d.h. Verkippungswinkel der Kristallachse um < 2° beseitigen lassen, ohne dass ein Materialverlust am Einkristall auftritt. Offenbar können sich bei diesen Temperaturen Salzionen auf ihren Gitterplätzen erleichtert umordnen.

Vorzugsweise wird beim Tempern ein feinteiliges Calciumfluoridpulver mit einer mittleren Korngröße von 100 nm - 1 mm verwendet. Übliche mittlere Korngrößen betragen 1 - 200 µm, vorzugsweise 5 - 100 µm und insbesondere von 10 - 50 µm. Die Oberfläche des feinteiligen Calciumfluoridpulvers sollte mindestens das 10fache, vorzugsweise mindestens das 100fache der Oberfläche des zu tempernden Gutes betragen. In besonders bevorzugten Ausführungsformen weist das Pulver mindestens das 1.000fache, in manchen Fällen das 5.000fache oder sogar 10.000fache der Oberfläche des Tempergutes auf.

Besonders bevorzugt ist es, die zu tempernden Kristalle und gefertigten Optiken direkt in das Temperpulver einzubetten, so dass dies einen innigen direkten Kontakt zum Pulver hat. Es hat sich nämlich gezeigt, dass sich hierbei besonders gut störende Verunreinigungen entfernen lassen.

Zur Entfernung von vorhandenem Sauerstoff im Kristallgitter enthält das Calciumfluoridpulver vorzugsweise zusätzlich mindestens einen Scavenger. Bevorzugte Scavenger sind PbF₂, ZnF₂, SnF₂, Grafit sowie andere niedrig schmelzende Fluoride und/oder Fluorverbindungen, die mit Sauerstoff flüchtige Verbindungen eingehen. Ein weiterer bevorzugter Scavenger ist XeF₂, welches bei Raumtemperatur fest ist, sich jedoch beim Erwärmen in Xe-Gas und F₂-Gas zersetzt und so als Niedrigtemperatur-Scavenger dient. Die bevorzugten Korngrößen der Scavenger entsprechen denen des CaF₂-Pulvers, sie können jedoch von diesen verschieden sein.

In einer besonders bevorzugten Ausführungsform enthält das beim Tempern zugesetzte Pulver feinteiligen Kohlenstoff, insbesondere Grafit.

Besonders bevorzugt ist ein Tempern oberhalb 1200°C, wobei oberhalb 1210°C besonders bevorzugt ist. Als obere Tempergrenze sollte 1415°C vorzugsweise 1370°C nicht überschritten werden. Üblicherweise beträgt die obere Tempertemperatur 1300°C. Es hat sich erfindungsgemäß auch gezeigt, dass vorzugsweise beim Tempern und/oder beim Gettern mit den Scavengern im Kristall eine möglichst homogene Temperatur herrschen sollte, die üblicherweise an keiner Stelle im Kristall um mehr als 5°C, insbesondere mehr als 2°C, vorzugsweise mehr als 1°C verschieden ist.

Es hat sich als zweckmäßig erwiesen beim Tempern zuerst auf eine Temperatur von 350°C-600°C , insbesondere 350°C-500°C zu erwärmen, um bei der Bearbeitung des Calciumfluorid-Kristalles sowie bei der Lagerung und beim Anfassen mit der Hand eingebrachtes Wasser zu entfernen. Besonders bevorzugt ist eine Erwärmung von 350°C-400°C. Dies geschieht vorzugsweise unter Vakuum. Die Wassertrocknung beträgt üblicherweise 12-45, vorzugsweise 24 Stunden.

Es hat sich auch als zweckmäßig erwiesen, das Tempern unter Schutzgas durchzuführen. Übliche Schutzgase sind Stickstoff, Helium, Argon und/oder Xenon.

In einer besonders bevorzugten Ausführungsform wird das Tempern auch in einer fluorhaltigen Atmosphäre, insbesondere einem fluorhaltigen Schutzgas durchgeführt. Hierbei wird Fluorgas in einen Temperofen bzw. in ein das Tempergut enthaltendes Tempergefäß eingeleitet und/oder durch Verdampfen freigesetzt. Weitere reaktive Fluorgase sind Tetrafluormethan sowie andere Fluorkohlenstoffe oder Fluorkohlenwasserstoffe.

Eine besonders bevorzugte fluorhaltige Atmosphäre ist eine HF-Atmosphäre. In einer weiteren bevorzugten erfindungsgemäßen Ausführungsform wird die fluorhaltige Atmosphäre zusammen mit einem Schutzgas verwendet. Zweckmäßigerweise enthält die dabei entstehende Gasmischung 0,1-20% Fluorgas, insbesondere 1-10%. Eine besonders bevorzugte Mischung ist eine Mischung aus HF und N₂.

In einer ganz besonders bevorzugten Ausführungsform wird die fluorhaltige Atmosphäre in Form von fluorfreisetzenden Festkörpern wie beispielsweise XeF₂ eingebracht. XeF₂ ist bei Raumtemperatur ein Festkörper, der sich bei einer Temperatur oberhalb 190°C zu Xe und F₂-Gas zersetzt. Beispielsweise wird es luftdicht verschlossen in einen Teflonbeutel eingesetzt.

Es hat sich als besonders zweckmäßig erwiesen, dass das Tempern in einer reduzierenden Atmosphäre durchgeführt wird. Eine reduzierende Atmosphäre wird beispielsweise durch den Zusatz von Grafitpulver erreicht, welches mit Wasser unter Ausbildung von CO/CO₂ und CH₄ reagiert, wobei CH₄ selbst eine reduzierende Wirkung aufweist. Auch das teilweise gasförmige Bleifluorid weist gegenüber Calciumoxid eine reduzierende sauerstoffentziehende Wirkung auf. Auf diese Weise können im Calciumkristall vorliegendes oder durch Wasseranlagerung entstandenes Calciumoxid zu Calciumfluorid umgewandelt werden, was sowohl der Schleierbildung als auch der Verringerung von Kleinwinkelkorngrenzen dient.

Auch hat es sich als zweckmäßig erwiesen, im Inneren des das Tempergut enthaltenden Tempergefäßes einen Caiciumfluorid-Partialdruck von 0,1-10 mbar, vorzugsweise 0,7-1,5 mbar, insbesondere 0,8-1 mbar aufrecht zu erhalten. Dabei ist das Tempergefäß vorzugsweise derart ausgestaltet, dass es zwar nicht gas-dicht ist, jedoch nur geringe Durchflussraten aufweist und damit nur einen geringen Abtransport von verdampften Ver-unreinigungen wie Wasser und Bleioxid oder CO₂ ermöglicht, diesen jedoch nicht vollständig unterdrückt. Dadurch kann die das Tempergut umgebende Atmosphäre nur geringfügig ab-diffundieren und es herrscht ein quasi stationärer Zustand solange noch ausreichend Temperpulver und/oder Schutz- bzw. Fluorgas vorhanden ist.

Das Tempergefäß sowie der gesamte Temperofen besteht vorzugsweise aus Grafit. Auf diese Weise werden unerwünschte Reaktionen vermieden. Darüber hinaus ist Grafit auch gegen die bei den Temperaturen äußerst aggressive Flusssäure besonders beständig.

Vorzugsweise wird erfindungsgemäß zuerst auf eine Temperatur von 200-450°C, vorzugsweise 300-400°C erwärmt und bei dieser Temperatur über eine längere Zeit, üblicherweise mindestens 10 Stunden, insbesondere mindestens 20 Stunden, die Temperatur gehalten. Dabei hat es sich als zweckmäßig erwiesen, in dieser Verfahrensstufe ein Vakuum anzulegen, um das bei diesen Temperaturen desorbierte Wasser zu entfernen. Anschließend wird auf 800°C hochgeheizt und langsam unter einer Erhöhung der Temperatur von 1-30°C/Stunde, vorzugsweise 5-20°C, insbesondere 8-12°C auf 900°C erwärmt, wobei die Scavenger reagieren. Danach wird vorzugsweise zwischen 1200°C bis maximal 1300°C, üblicherweise bis 1220°C für 1-24 Stunden, vorzugsweise 2-10 Stunden, insbesondere 3-5 Stunden getempert und danach auf 850°C abgekühlt, wonach wieder auf 950°C erwärmt wird. Auf diese Weise wird das Ausleiten von Defekten deutlich verbessert, ohne dass eine merkliche Diffusion, z.B. Schleierbildung stattfindet. Danach wird mit einer Geschwindigkeit von 0,5°C bis 5°C/h, vorzugsweise 1-3°C langsam auf 680-740°C, insbesondere 690-710°C abgekühlt. Anschließend wird die Abkühlungsrate leicht auf maximal 5°C/Stunde, zweckmäßigerweise etwa 3°C/h erhöht und ab ca. 400° wird mit einer Geschwindigkeit von 5-10°C/h auf Raumtemperatur abgekühlt.

Die Erfindung soll durch das folgende Beispiel näher erläutert werden.

Ein mittels dem Stockbager Bridgman-Verfahren hergestellter Einkristall mit einem Durchmesser von 300 mm und einer Dicke von 600 mm wird in einem Grafittiegel zwischen einem feinteilig zermahlenem Calciumfluoridpulver eingebettet, welches 20% PbF₂-Pulver, sowie 10 Gew.-% Grafit enthält. Darüber hinaus wird noch ein Teflonbeutel der XeF₂ enthält zugegeben. Dabei ist die zu tempernde Kristallscheibe von allen Seiten rundherum vollständig mit dem feinteiligen Pulver in Kontakt. Die Oberfläche des Calciumfluorid-Anteils im Gesamtpulver beträgt das 3000fache der Oberfläche des Einkristalls. Danach wird langsam auf 370°C unter Vakuum erwärmt, wobei eventuell vorliegendes Wasser über einen Zeitraum von 24 Stunden entfernt wird. Anschließend wird auf 800°C erwärmt und der darüber liegende Scavengerbereich mit einer Geschwindigkeit von 10°C/h bis auf 900°C durchfahren, wonach auf 1220°C erwärmt und die Temperatur vier Stunden lang beibehalten wird. Im Inneren des mit einem Deckel verschlossenen Grafitgefäßes herrscht ein Druck von 10 mbar, der aus der Summe der Partialdrücken von Calciumfluorid, Bleifluorid, Grafitdampf/CO sowie Xenon und Fluorgas gebildet wird. Anschließend wird auf 850°C abgekühlt und danach wieder auf 950°C erwärmt, wonach mit einer Geschwindigkeit von 2°C/h auf 700°C abgekühlt wird. Dann wird mit 3°C/h und zum Schluss mit 5-10°C/h auf Raumtemperatur abgekühlt. Auf diese Weise wurde ein hochhomogener Einkristall erhalten, der keine merkliche Spannungsdoppelbrechung aufwies, d. h. dass dessen Unterschiede in der Brechzahl an allen Stellen wesentlich kleiner waren als 1 x 10⁻⁶. Darüber hinaus wurden keine mit bloßem Auge erkennbaren optischen Streuzentren festgestellt.

## Patentansprüche

1. Verfahren zur Herstellung von hochhomogenen, großformatigen, insbesondere bearbeiteten Einkristallen aus Calciumfluorid durch Tempern bei erhöhter Temperatur, wobei der Kristall während des Temperns in einem mit einer Abdeckung versehenen Tempergefäß gelagert wird, **dadurch gekennzeichnet, dass** man in das Tempergefäß ein Calciumfluoridpulver einbringt und dass man den Kristall mindestens zwei Stunden lang oberhalb 1150°C erwärmt.

2. Verfahren nach Anspruch 1, **dadurch gekennzeichnet, dass** das Tempergefäß zumindest teilweise aus Kohlenstoff besteht.

3. Verfahren nach einem der vorhergehenden Ansprüche, **dadurch gekennzeichnet dass** man in das Tempergefäß PbF₂-Pulver, Grafitpulver oder Mischungen davon einbringt.

4. Verfahren nach einem der vorhergehenden Ansprüche **dadurch gekennzeichnet, dass** man das Tempern unter einer reduzierenden Atmosphäre im Tempergefäß durchführt.

5. Verfahren nach einem der vorhergehenden Ansprüche **dadurch gekennzeichnet, dass** man unter Schutzgas tempert.

6. Verfahren nach einem der vorhergehenden Ansprüche **dadurch gekennzeichnet, dass** man als Schutzgas N₂, Ar, He, Xe verwendet.

7. Verfahren nach einem der vorhergehenden Ansprüche **dadurch gekennzeichnet, dass** man unter einer fluorhaltigen Atmosphäre tempert.

8. Verfahren nach Anspruch 7, **dadurch gekennzeichnet, dass** man als fluorhaltige Atmosphäre F₂, HF, CF₄, Fluorkohlenstoffe und/oder Fluorkohlenwasserstoffe verwendet.

9. Verfahren nach einem der vorhergehenden Ansprüche **dadurch gekennzeichnet, dass** das CaF₂, PbF₂ und/oder Grafitpulver eine Korngröße von 100 nm-200 µm aufweist.

10. Verfahren nach einem der vorhergehenden Ansprüche **dadurch gekennzeichnet, dass** der zu tempernde Einkristall beim Tempern einen direkten Kontakt zum Pulver aufweist.

11. Verfahren nach einem der vorhergehenden Ansprüche **dadurch gekennzeichnet, dass** man das Erwärmen bei einer Temperatur zwischen 1150 und 1170°C stoppt, bei dieser Temperatur mindestens fünf Stunden ausharrt und dann langsam auf die eigentliche Temperstufe weiter erwärmt.

12. Verwendung von nach dem Verfahren der Ansprüche 1-11 erhaltenen Einkristallen zur Herstellung von Linsen, Prismen, Lichtleitstäben, optischen Fenstern sowie.optischen Komponenten für die DUV-Fotolithographie, Steppern, Excimerlasern, Wafern, Computerchips, sowie integrierten Schaltungen und elektronischen Geräten, die solche Schaltungen und Chips enthalten.

## Claims

1. Method for making uniform, large-size, in particular machined single crystals of calcium fluoride, by tempering at elevated temperature, the crystal being held in a tempering vessel provided with a cover during the tempering, **characterized in that** a calcium fluoride powder is introduced into the tempering vessel, and **in that** the crystal is heated for at least two hours at temperatures above 1150°C.

2. Method according to Claim 1, **characterized in that** the tempering vessel at least partially comprises carbon.

3. Method according to one of the preceding claims, **characterized in that** PbF₂ powder, graphite powder or mixtures thereof is introduced into the tempering vessel.

4. Method according to one of the preceding claims, **characterized in that** the tempering is carried out under a reducing atmosphere in the tempering vessel.

5. Method according to one of the preceding claims, **characterized in that** tempering is carried out under a protective gas.

6. Method according to one of the preceding claims,
**characterized in that** the protective gas used is N₂, Ar, He or Xe.

7. Method according to one of the preceding claims, **characterized in that** tempering is carried out under a fluorine-containing atmosphere.

8. Method according to Claim 7, **characterized in that** the fluorine-containing atmosphere used is F₂, HF, CF₄, fluorocarbons and/or fluorohydrocarbons.

9. Method according to one of the preceding claims, **characterized in that** the CaF₂, PbF₂ and/or graphite powder has a grain size of 100 nm-200 µm.

10. Method according to one of the preceding claims, **characterized in that** the single crystal which is to be tempered is in direct contact with the powder during the tempering.

11. Method according to one of the preceding claims, **characterized in that** the heating is stopped at a temperature between 1150 and 1170°C, this temperature is maintained for at least five hours and then further heating to the actual tempering level is carried out slowly.

12. Use of single crystals obtained using the method of Claims 1-11 for making lenses, prisms, light-conducting rods, optical windows and optical components for DUV photolithography, steppers, excimer lasers, wafers, computer chips and integrated circuits and electronic devices containing such circuits and chips.

## Revendications

1. Procédé de fabrication de cristaux uniques de grand format, à homogénéité élevée, particulièrement traités, en fluorure de calcium, par trempe à température élevée, le cristal étant entreposé pendant la trempe dans un récipient de trempe pourvu d'un couvercle, **caractérisé en ce que** l'on introduit dans le récipient de trempe une poudre de fluorure de calcium et **en ce que** l'on échauffe le cristal au moins pendant deux heures à une température supérieure à 1150°C.

2. Procédé selon la revendication 1, **caractérisé en ce que** le récipient de trempe se compose au moins partiellement de carbone.

3. Procédé selon l'une quelconque des revendications précédentes, **caractérisé en ce que** l'on introduit dans le récipient de trempe une poudre de PbF₂, une poudre de graphite ou des mélanges de ces derniers.

4. Procédé selon l'une quelconque des revendications précédentes, **caractérisé en ce que** l'on effectue la trempe dans le récipient de trempe sous une atmosphère réductrice.

5. Procédé selon l'une quelconque des revendications précédentes, **caractérisé en ce que** l'on procède à la trempe sous un gaz de protection.

6. Procédé selon l'une quelconque des revendications précédentes, **caractérisé en ce que** l'on utilise en tant que gaz de protection le N₂, l'Ar, l'He, le Xe.

7. Procédé selon l'une quelconque des revendications précédentes, **caractérisé en ce que** l'on procède à la trempe sous une atmosphère contenant du fluor.

8. Procédé selon la revendication 7, **caractérisé en ce que** l'on utilise, en tant qu'atmosphère contenant du fluor, F₂, HF, CF₄, des carbures fluorés et/ou des hydrocarbures fluorocarbonés.

9. Procédé selon l'une quelconque des revendications précédentes, **caractérisé en ce que** la poudre de CaF₂, de PbF₂ et/ou la poudre de graphite présente une granulométrie de 100 nm - 200 µm.

10. Procédé selon l'une quelconque des revendications précédentes, **caractérisé en ce que** le cristal unique à tremper présente, lors de la trempe, un contact direct avec la poudre.

11. Procédé selon l'une quelconque des revendications précédentes, **caractérisé en ce que** l'on interrompt l'échauffement à une température comprise entre 1150 et 1170EC, **en ce que** l'on se maintient à cette température pendant au moins cinq heures et ce que l'on poursuit alors l'échauffement lentement pour parvenir à l'étape de trempe proprement dite.

12. Utilisation des cristaux uniques obtenus conformément au procédé des revendications 1-11, en vue de la fabrication de lentilles, de prismes, de tiges de guidage de la lumière, de fenêtres optiques ainsi de composants optiques pour la photolithographie Ultra Violet Profond, de dispositifs "steppers", de lasers excimère, de pastilles, de puces d'ordinateur tout comme de circuits intégrés et d'appareils électroniques, qui contiennent des circuits et des puces de ce genre.
